(19) **Europäisches Patentamt / European Patent Office / Office européen des brevets**

(11) **EP 1 757 665 B1**

(12) **EUROPEAN PATENT SPECIFICATION**

(45) Date of publication and mention
of the grant of the patent:
**22.02.2012 Bulletin 2012/08**

(51) Int Cl.:
*C09G 1/02* (2006.01)    *H01L 21/321* (2006.01)
*H01L 21/768* (2006.01)    *B24B 37/04* (2012.01)

(21) Application number: **06119461.9**

(22) Date of filing: **24.08.2006**

(54) **Aqueous dispersion for chemical mechanical polishing, kit for preparing the aqueous dispersion for a chemical mechanical polishing process, and process for producing semiconductor devices**

Wässrige Dispersionsaufschlämmung für chemisch-mechanisches Polierverfahren, Kit zur Herstellung dieser Dispersionsaufschlämmung für ein chemisch-mechanisches Polierverfahren, und Verfahren zur Herstellung von Halbleitervorrichtungen

Dispersion aqueuse pour le polissage mécano-chimique, kit pour la préparation de cette dispersion pour le polissage mécano-chimique, et procédé pour la fabrication de dispositifs semiconducteurs

(84) Designated Contracting States:
**DE FR GB IT**

(30) Priority: **24.08.2005 JP 2005242895**

(43) Date of publication of application:
**28.02.2007 Bulletin 2007/09**

(73) Proprietor: **JSR Corporation
Minato-ku
Tokyo 105-8640 (JP)**

(72) Inventors:
• **Shida, Hirotaka
Tokyo 1058640 (JP)**
• **Takemura, Akihiro
Tokyo 1058640 (JP)**
• **Hattori, Masayuki
Yatomi-shi
Aichi (JP)**
• **Minamihaba, Gaku
Tokyo
Tokyo (JP)**

• **Fukushima, Dai
Tokyo
Tokyo (JP)**
• **Kurashima, Nobuyuki
Tokyo
Tokyo (JP)**
• **Yamamoto, Susumu
Tokyo
Tokyo (JP)**
• **Tateyama, Yoshikuni
Tokyo
Tokyo (JP)**
• **Yano, Hiroyuki
Tokyo
Tokyo (JP)**

(74) Representative: **TBK
Bavariaring 4-6
80336 München (DE)**

(56) References cited:
**WO-A-2005/047410    US-A1- 2005 037 693**

**Description**

**TECHNICAL FIELD**

The present invention relates to an aqueous dispersion for chemical mechanical polishing, a chemical mechanical polishing process, and a process for producing semiconductor devices. More particularly, the invention relates to an aqueous dispersion for chemical mechanical polishing of metal films, a kit for preparing the aqueous dispersion, a process for chemically mechanically polishing metal films, and a process for producing semiconductor devices having damascene wirings.

**BACKGROUND ART**

Cu damascene wirings on high-performance LSI are formed by using Chemical mechanical polishing (CMP). CMP performs first polishing which polishes mainly Cu, and second polishing which polishes extra metals and insulating film. It is necessary that the first polishing polish Cu at 800 nm/min and do not substantially polish a barrier metal such as Ta or Ti while the Cu dishing should not exceed 20 nm in depth. When the insulating film is made of a low-kmaterial, it will be peeled or broken by high polishing friction. Accordingly, the use of conventional CMP aqueous dispersions (CMP slurries) having high polishing friction is increasingly difficult.

In the second polishing, it is necessary that Cu scratches and corrosion and scratches on the insulating film are reduced by polishing the surface at low friction to increase hydrophilicity of the surface and the polishing pad as with the first polishing. Further, the improvements of Cu dishing and erosion of the insulating film by the second polishing are desired. However, conventional silicone surface active agents strongly act on abrasive grain silica to produce coarse particles, making it difficult to prevent scratches and stabilize the removal rate.

To satisfy the requirements for the first and second polishing as described above, slurries containing polyvinylpyrrolidone (PVP) are proposed (for example, JP-A-2003-282494, JP-A-2002-270549 and JP-A-2002-517593). However, the existing slurries are incapable of preventing the Cu dishing and Cu corrosion and scratches on the insulating film while showing high stability in the formation of Cu damascene wiring. Consequently, performances required for next-generation LSI are not fully satisfied.

WO 2005047410 (A1) discloses a polishing composition, comprising (A) a compound having three or more azole moieties, (B) an oxidizing agent, and (C) one or more species selected from among an amino acid, an organic acid, and an inorganic acid.

US 2005037693 (A1) discloses a chemical mechanical polishing aqueous dispersion comprises a component (A) composed of abrasive grains, a component (B) composed of at least one of quinolinecarboxylic acid and pyridinecarboxylic acid, a component (C) composed of an organic acid other than quinolinecarboxylic acid and pyridinecarboxylic acid and a component (D) composed of an oxidizing agent, wherein a mass ratio (WB/WC) of the content (WB) of the component (B) to the content (WC) of the component (C) is not less than 0.01 and less than 2, and the concentration of an ammonia component composed of ammonia and ammonium ion is not more than 0.005 mol/litter. According to the chemical mechanical polishing aqueous dispersion, various layers to be processed can be polished with high efficiency, and a sufficiently planarized polished surface of high precision can be obtained.

**OBJECT OF THE INVENTION**

It is an object of the invention to provide a CMP aqueous dispersion capable of uniformly and stably polishing a metal film at low friction without causing defects in the metal film and the insulating film, and capable of excellent removal selectivity with respect to a Cu film. It is another object of the invention to provide a kit for preparing the CMP aqueous dispersion. It is a further object of the invention to provide a process capable of uniformly and stably polishing a metal film without causing defects in the metal film and the insulating film, and capable of selective CMP of a Cu film. It is another object of the invention to provide a process for producing very reliable semiconductor devices having damascene wirings.

**DISCLOSURE OF THE INVENTION**

An aqueous dispersion for chemical mechanical polishing according to the present invention comprises water, a vinylpyrrolidone homopolymer having a weight-average molecular weight of from 300,000 to 1,500,000 as determined by aqueous GPC , an oxidant, a protective film-forming agent and abrasive grains, the protective film-forming agent comprising a first metal compound-forming agent which forms a water-insoluble metal compound, and a second metal compound-forming agent which forms a water-soluble metal compound.

The water-insoluble metal compound is preferably a water-insoluble complex, and the water-soluble metal compound is preferably a water-soluble complex.

A chemical mechanical polishing process according to the present invention comprises a step of bringing a semiconductor substrate having a metal film into contact with a polishing pad attached to a turntable; and a step of polishing a surface of the metal film while dropping the above aqueous dispersion on the polishing pad.

A process for producing semiconductor devices according to the present invention comprises:

a step of forming an insulating film on a semiconductor substrate;
a step of forming a concave groove in the insulating film;
a step of depositing a metal in the concave groove and on the insulating film to form a metal film; and
a step of removing at least part of the metal film deposited on the insulating film by chemical mechanical polishing using the above aqueous dispersion.

A first kit for preparing an aqueous dispersion for chemical mechanical polishing according to the present invention comprises a liquid (I) and a liquid (II), the liquids being mixed to give the aforesaid aqueous dispersion, wherein the liquid (I) is an aqueous dispersion containing water, the vinylpyrrolidone homopolymer, the protective film-forming agent and the abrasive grains, and the liquid (II) contains water and the oxidant.

A second kit for preparing an aqueous dispersion for chemical mechanical polishing according to the present invention comprises a liquid (III) and a liquid (IV), the liquids being mixed to give the aforesaid aqueous dispersion, wherein the liquid (III) is an aqueous dispersion containing water and the abrasive grains, the liquid (IV) contains water and the protective film-forming agent, the liquid (III) and/or the liquid (IV) contain the vinylpyrrolidone homopolymer, and the liquid (III) and/or the liquid (IV) contain the oxidant.

A third kit for preparing an aqueous dispersion for chemical mechanical polishing according to the present invention comprises a liquid (V), a liquid (VI) and a liquid (VII), the liquids being mixed to give the aforesaid aqueous dispersion, wherein the liquid (V) is an aqueous dispersion containing water and the abrasive grains, the liquid (VI) contains water and the protective film-forming agent, the liquid (VII) contains water and the oxidant, and at least one of the liquids (V), (VI) and (VII) contain the vinylpyrrolidone homopolymer.

## BRIEF DESCRIPTION OF THE DRAWINGS

Fig. 1 is a sectional view of a semiconductor device before chemical mechanical polishing in the process for producing semiconductor devices of the invention;
Fig. 2 is a sectional view of the semiconductor device shown in Fig. 1 after first chemical mechanical polishing;
Fig. 3 is a schematic view illustrating CMP;
Fig. 4 is a sectional view of the semiconductor device shown in Fig. 1 after second chemical mechanical polishing;
Fig. 5 is a sectional view of a semiconductor device before chemical mechanical polishing in the process for producing semiconductor devices of the invention; and
Fig. 6 is a sectional view of the semiconductor device shown in Fig. 5 after chemical mechanical polishing.

## PREFERRED EMBODIMENTS OF THE INVENTION

[CMP aqueous dispersion]

The CMP aqueous dispersion according to the present invention contains water, a high-molecular weight vinylpyrrolidone homopolymer, an oxidant, a protective film-forming agent and abrasive grains. These components will be described below.

<vinylpyrrolidone homopolymer>

The vinylpyrrolidone homopolymer (PVP) has a weight-average molecular weight (Mw) in terms of polyethylene glycol from 300, 000 to 1, 500, 000, more preferably from 500,000 to 1,200,000, particularly preferably from 650,000 to 1,100,000, as determined by aqueous GPC (gel permeation chromatography). When the weight-average molecular weight is in this range, the CMP aqueous dispersion shows reduced polishing friction, prevents the dishing and corrosion of the metal film, and can polish the metal film stably. When the weight-average molecular weight is below the lower limit, the removal selectivity with respect to the Cu film is often lowered. When the weight-average molecular weight is excessively high, a practical removal rate with respect to the metal film is not often obtained, and PVP causes aggregation of the abrasive grains in a slurry supply apparatus and the aggregated abrasive grains will increase scratches on Cu.

PVP preferably has a K value exceeding 57, still preferably from more than 57 to 106, even more preferably from 65 to 106, particularly preferably from 76 to 100, optimally from 82 to 97, as determined by the Fikentscher method. When the K value is in this range, the CMP aqueous dispersion shows reduced polishing friction, prevents the dishing and corrosion of the metal film, and can polish the metal film stably. When the K value is below the lower limit, the removal selectivity with respect to the Cu film is often lowered. When the K value is excessively high, a practical removal rate with respect to the metal film is not often obtained, and PVP causes aggregation of the abrasive grains in a slurry supply apparatus and the aggregated abrasive grains will increase scratches on Cu. The higher the molecular weight of PVP, the higher the K value.

The K value may be obtained as follows. When the K value will be less than 20, a 5% (g/100 ml) PVP solution is measured for viscosity, and when the K value will be 20 or more, a 1% (g/100 ml) PVP solution is measured for viscosity. The sample concentration is based on dry weight. When the K value will be 20 or more, exactly 1. 0 g of the sample is weighed in a 100-ml measuring flask and distilled water is added at room temperature. The sample is completely dissolved by shaking the flask, followed by adding distilled water to make the total volume exactly 100 ml. The sample solution is allowed to stand in a constant-temperature bath (25±0.2°C) for 30 minutes and is measured for viscosity with an Ubbelohde viscometer. The solution is allowed to flow between two marking lines, and the elapsed time is measured. This measurement is repeated several times, and the average is obtained. To determine the relative viscosity, the same measurement is performed with distilled water. The two flowing times obtained are corrected based on Hagenbach-Couette correction.

$$\text{K value} = \frac{\sqrt{300C\log Z + (C + 1.5C\log Z)^2} + 1.5C\log Z - C}{0.15C + 0.003C^2}$$

In the above formula, Z is a relative viscosity ($\eta_{rel}$) of a solution having a concentration C, and C is a concentration (%: g/100 ml). The relative viscosity $\eta_{rel}$ is obtained from the following formula:

$$\eta_{rel} = (\text{Solution flowing time}) \div (\text{Water flowing time})$$

(Polymerization of PVP)

(Polymerization of PVP)

PVP used in the invention may be prepared as follows. To an aqueous vinylpyrrolidone (hereinafter, VP) solution, water-soluble organic peroxide and sulfite are added as redox polymerization initiators to initiate polymerization, resulting in a vinylpyrrolidone homopolymer. Herein, the vinylpyrrolidone is generally N-vinyl-2-pyrrolidone. The vinylpyrrolidone polymers include vinylpyrrolidone homopolymers

Polymerization of VP may be performed by solution polymerization in an aqueous medium. For example, an aqueous water-soluble organic peroxide solution and an aqueous sulfite solution may be added to an aqueous VP solution to initiate polymerization.

The aqueous VP solution may have a VP concentration of 10 to 60% by weight, preferably 20 to 50% by weight. When the VP concentration is too low, the productivity will be bad and the cost will be increased. When the concentration is too high, the solution increases the viscosity over time during polymerization to make stirring difficult, increasing the possibility of hindered reaction.

Because the polymerization system is water-based and the redox initiator reducing agent is water-soluble, the organic peroxide is preferably soluble in water.

Examples of the water-soluble organic peroxides include all kinds of hydroperoxides such as tert-butyl hydroperoxide, cumene hydroperoxide, tert-hexyl hydroperoxide and p-menthane hydroperoxide, and water-soluble peroxyesters such as tert-butyl peroxyacetate. Tert-butyl hydroperoxide is preferable as initiator because by-products such as tert-butanol may be easily removed by heating or reducing the pressure.

The amount of the water-soluble organic peroxide is preferably from 0. 005 to 5% by weight, more preferably from 0. 02 to 3% by weight relative to VP. When the amount of the water-soluble organic peroxide is too small, the polymerization rate is decreased, often resulting in bad productivity. When the amount of the water-soluble organic peroxide is too large, the extra peroxide remains as impurity after the polymerization to lower the quality, and the polymer obtained will hardly have a high molecular weight.

The water-soluble organic peroxide may be added in the form of solid or aqueous solution.

Examples of the sulfites include ammonium salts, alkali metal salts (such as sodium salts and potassium salts) and alkaline earth metal salts (such as magnesium salts and calcium salts) of sulfurous acids including sulfurous acid, thiosulfuric acid, hyposulfurous acid and meta-sulfurous acid. Of these sulfites, ammonium sulfite is preferable because it does not become ash and is easily removed due to high volatility.

The amount of the sulfite is preferably from 0.005 to 10% by weight, more preferably from 0.02 to 7% by weight relative to VP. When the amount of the sulfite is too small, the monomer (s) will not be polymerized at high conversion ratio and will remain unreacted in large amounts. When the amount is too large, it is more likely that the sulfite or sulfate (oxide of the sulfite) remains in PVP.

The sulfite may be added in the form of aqueous solution to the aqueous VP solution.

The molar ratio of the water-soluble organic peroxide to the sulfite added is preferably in the range of 1:0.5 to 1:20, more preferably 1:1 to 1:10 to minimize the remaining water-soluble organic peroxide in PVP.

The polymerization temperature is preferably from 10 to 90°C. When the polymerization temperature is too low, the polymerization rate is low and the productivity is often deteriorated. When the polymerization temperature is too high, the radical concentration in the reaction system is increased and termination reaction is accelerated. Consequently, the initiators are not effectively used and the amounts thereof often should be increased.

The polymerization reaction substantially completes in 0.5 to 10 hours.

The weight-average molecular weight and K value of PVP may be increased by reducing the amounts of the water-soluble organic peroxide and the sulfite.

Alternatively, PVP for use in the invention may be produced as described in JP-A-2003-40911.

PVP preferably accounts for 0.001 to 0.5% by weight, more preferably 0.005 to 0.3% by weight, particularly preferably 0.01 to 0.1% by weight of the CMP aqueous dispersion. When PVP accounts for less than 0.001% by weight, the aqueous dispersion is often incapable of low polishing friction and the temperature of the polishing pad is often increased. Consequently, polishing stops more frequently (CMP stop), and the capability of removing Cu in a Cu overplating part is often lowered. When PVP accounts for more than 0.5% by weight, the Cu-removal rate is often lowered, and the CMP aqueous dispersion has too high a viscosity and is not often supplied stably on the polishing pad. Consequently, the temperature of the polishing pad is increased and polishing produces uneven effects (low inplane uniformity), often resulting in varied Cu- removal rates and Cu-dishing sizes. To avoid these problems, the viscosity of the CMP aqueous dispersion is preferably less than 2 mPa·s.

When the CMP aqueous dispersion is used in chemical mechanical polishing which polishes a wiring metal such as Cu while leaving a barrier metal (hereinafter, first polishing), the PVP content is preferably in the range of 0.005 to 0.5% by weight, more preferably 0.01 to 0.3% by weight, particularly preferably 0.02 to 0.2% by weight. This PVP content achieves low friction, high removal rate and low barrier metal-removal rate. When the PVP content is in the above range, the Cu dishing and erosion of the insulating film are prevented, and defects such as Cu corrosion and scratches are reduced, and the capability of removing Cu in the Cu overplating part is improved to increase polishing stability and uniformity of removal rate.

When the CMP aqueous dispersion is used in chemical mechanical polishing which polishes the barrier metal to expose an insulating film (hereinafter, second polishing), the PVP content is preferably in the range of 0.001 to 0.3% by weight, more preferably 0.002 to 0.2% by weight, particularly preferably 0.005 to 0.1% by weight. This PVP content achieves low friction and prevents the Cu dishing and erosion of the insulating film. When the PVP content is in the above range, defects such as Cu corrosion and scratches are reduced, and the polishing stability and uniformity of removal rate are increased.

PVP may be used singly or in combination of two or more kinds different in weight-average molecular weight as long as the weight-average molecular weights and total PVP content are in the aforesaid ranges.

<Oxidant>

The oxidants for use in the invention include ammonium persulfate, potassium persulfate, hydrogen peroxide, ferric nitrate, diammonium cerium nitrate, iron sulfate, ozone and potassium periodate. The oxidants may be used singly or in combination of two or more kinds. In view of oxidizing power, compatibility with the protective film and handling properties, ammonium persulfate, potassium persulfate and hydrogen peroxide are preferred. The oxidant preferably accounts for 0.05 to 5% by weight, more preferably 0.08 to 3% by weight of the CMP aqueous dispersion. When the oxidant accounts for less than 0.05% by weight, the aqueous dispersion is often incapable of sufficient removal rate. When the oxidant accounts for more than 5% by weight, corrosion and dishing in the metal film such as Cu film are often increased.

<Protective film-forming agent>

The protective film-forming agent contains a first metal compound-forming agent which forms a water-insoluble metal compound, and a second metal compound-forming agent which forms a water-soluble metal compound. The water-insoluble metal compound is preferably a water-insoluble complex, and the water-soluble metal compound is preferably a water-soluble complex. As used herein, the term water-insoluble means that the compound is not substantially dissolved in water, and the water-insoluble metal compounds in the invention include compounds hardly soluble in water provided that the wet etching rate of the compound in the presence of the oxidant is less than 3 nm/min. The water-soluble metal compounds include compounds having a wet etching rate of 3 nm/min or more. The protective film-forming agent preferably accounts for 0.001 to 3.0% by weight, more preferably 0.05 to 2.0% by weight of the CMP aqueous dispersion. When the protective film-forming agent accounts for less than 0.001% by weight, the Cu dishing often exceeds 20 nm in depth. When the protective film-forming agent accounts for more than 3.0% by weight, the removal rate is often lowered.

The first metal compound-forming agent forms a water-insoluble or hardly water-soluble metal compound, particularly complex, with a metal such as Cu. Examples of the first metal compound-forming agents include heterocyclic compounds having six-membered or five-membered hetero rings containing at least one nitrogen atom. Specific examples include quinaldinic acid, quinolinic acid, benzotriazole, benzimidazole, 7-hydrixy-5-methyl-1,3,4-triazaindolizine, nicotinic acid and picolinic acid.

Examples of the first metal compound-forming agents further include anionic surface active agents capable of forming metal compounds with a metal such as Cu. Alkylbenzenesulfonates are preferred, with examples including potassium dodecylbenzenesulfonate and ammonium dodecylbenzenesulfonate.

The first metal compound-forming agent preferably accounts for 0.0005 to 2.0% by weight, more preferably 0.0075 to 1.5% by weight of the CMP aqueous dispersion. When the first metal compound-forming agent accounts for less than 0.0005% by weight, the Cu dishing is often increased in size. When the first metal compound-forming agent accounts for more than 2.0% by weight, the aqueous dispersion is often incapable of sufficient Cu removal rate.

The first metal compound-forming agents may be used singly or in combination of two or more kinds.

The second metal compound-forming agent forms a water-soluble metal compound, particularly complex, and functions as a polishing accelerator. Examples thereof include amino acids such as glycine, alanine and tryptophan; organic acids such as formic acid, lactic acid, acetic acid, tartaric acid, fumaric acid, glycolic acid, phthalic acid, maleic acid, oxalic acid, citric acid, malic acid, malonic acid and glutaric acid; and basic salts such as ammonia, ethylenediamine and TMAH (tetramethylammonium hydroxide).

The second metal compound-forming agent preferably accounts for 0.0005 to 2.0% by weight, more preferably 0.0075 to 1.5% by weight of the CMP aqueous dispersion. When the second metal compound-forming agent accounts for less than 0.0005% by weight, the aqueous dispersion is often incapable of removing Cu at a sufficiently high rate. When the second metal compound-forming agent accounts for more than 2.0% by weight, the Cu dishing and Cu corrosion are often increased in size.

The second metal compound-forming agents may be used singly or in combination of two or more kinds.


<Abrasive grains>

Preferred examples of the abrasive grains include inorganic particles and organic-inorganic composite particles. The inorganic particles include fumed silica, fumed alumina and fumed titania synthesized by reacting silicon chloride, aluminum chloride or titanium chloride with oxygen and hydrogen in a gas phase by a fuming process; silica synthesized by hydrolysis and condensation of metal alkoxides by a sol-gel process; and high-purity colloidal silica synthesized by an inorganic colloid process and purification to remove impurities.

The types and structures of the organic-inorganic composite particles are not particularly limited as long as organic and inorganic particles are not easily separated during polishing. For example, the composite particles may be obtained by polycondensing alkoxysilane, aluminum alkoxide or titanium alkoxide in the presence of polymer particles such as polystyrene or polymethyl methacrylate, whereby the polycondensate such as polysiloxane, polyaluminoxane or polytitanoxane is formed on at least the surface of the polymer particles. The polycondensate may be directly bonded to the functional groups of the polymer particles, or may be bonded through a silane coupling agent or the like.

Alternatively, the organic-inorganic composite particles may be formed from the polymer particles, and silica particles, alumina particles or titania particles. In this case, the composite particles may be formed such that the silica particles or the like are on the surface of the polymer particles by means of a polycondensate such as polysiloxane, polyaluminoxane or polytitanoxane as a binder; or such that the functional groups of the silica particles or the like, for example hydroxyl groups, are chemically bonded with the functional groups of the polymer particles.

The organic-inorganic composite particles may be composed of organic particles and inorganic particles that have different zeta potential charges and are bonded by static electricity in an aqueous dispersion.

The zeta potential of the organic particles is usually negative over the entire pH range or a wide range of pH excluding low pH. When the organic particles have a carboxyl group or a sulfonic acid group, the zeta potential is more frequently negative. When the organic particles have an amino group, the zeta potential is sometimes positive in a specific pH range.

The zeta potential of the inorganic particles is highly dependent on pH. The inorganic particles have an isoelectric point at which the zeta potential is 0, and the zeta potential has a positive or negative charge below or above the pH level.

Accordingly, when specific organic and inorganic particles are mixed at a pH at which the zeta potential charge is reversed, the organic and inorganic particles are bonded by static electricity to produce composite particles. Even if the zeta potential charges are identical at a pH in the mixing, the pH may be adjusted after the mixing to give a reversed zeta potential charge to the organic or inorganic particles, particularly the inorganic particles, thereby bonding the organic and inorganic particles.

In the presence of the composite particles bonded by static electricity, alkoxysilane, aluminum alkoxide or titanium alkoxide may be polycondensed to form a polycondensate such as polysiloxane, polyaluminoxane or polytitanoxane on at least the surface of the composite particles.

The abrasive grains preferably have an average particle size of 5 to 1000 nm. The average particle size may be determined with a laser scattering diffraction analyzer or a transmission electron microscope. When the average particle size is less than 5 nm, the CMP aqueous dispersion may not achieve a sufficiently high removal rate. Average particle sizes exceeding 1000 nm may lead to dishing and erosion, and precipitation and separation of the abrasive grains. Consequently, it is often difficult that the aqueous dispersion be stable. The average particle size of the abrasive grains is more preferably in the range of 10 to 700 nm, particularly preferably 15 to 500 nm. When the average particle size is in this range, the CMP aqueous dispersion has a high removal rate, sufficiently prevents dishing and erosion, is resistant to precipitation and separation of the particles, and is stable.

If metal ions such as iron, nickel and zinc ions remain in chemically mechanically polished semiconductor devices, such residual ions frequently cause a lowered yield. In the event that the abrasive grains contain such metal ions, the content of the metal ions is generally not more than 10 ppm, preferably not more than 5 ppm, more preferably not more than 3 ppm, particularly preferably 1 ppm. It is needless to say that the abrasive grains are preferably free of such metal ions.

The abrasive grains preferably account for 0.01 to 5% by weight, more preferably 0.02 to 4% by weight of the CMP aqueous dispersion. When the abrasive grains account for less than 0.01% by weight, the aqueous dispersion often has an insufficient removal rate. When the abrasive grains account for more than 5% by weight, the cost will be increased and the CMP aqueous dispersion will be unstable.

<Surface active agent>

The CMP aqueous dispersion may contain a nonionic surface active agent, an anionic surface active agent or a cationic surface active agent as required. The nonionic surface active agents include those having a triple bond. Specific examples include acetylene glycols, ethylene oxide adducts thereof and acetylene alcohols. The nonionic surface active agents further include silicone surface active agents, polyvinyl alcohols, cyclodextrin, polyvinyl methyl ether and hydroxyethyl cellulose. The anionic surface active agents include fatty acid soaps, sulfates and phosphates. The cationic surface active agents include aliphatic amine salts and aliphatic ammonium salts. The surface active agents may be used singly or in combination of two or more kinds. Of the above surface active agents, the nonionic surface active agents having a lower average molecular weight than PVP are preferred. When the aqueous dispersion contains a high-molecular compound in addition to PVP, the removal rate may be drastically lowered and dishing may be drastically increased in size.

The surface active agent preferably accounts for 0.001 to 0.5% by weight, more preferably 0.05 to 0.3% by weight of the CMP aqueous dispersion. When the surface active agent content is in this range, the Cu dishing is sufficiently prevented.

<Properties of CMP aqueous dispersion>

The CMP aqueous dispersion is an aqueous dispersion of the above-described components in water. The viscosity is preferably less than 2 mPa·s. The viscosity may be adjusted by controlling the average molecular weight and content of PVP. When the viscosity of the CMP aqueous dispersion is not less than 2 mPa·s, the aqueous dispersion is not often supplied on the polishing pad stably. Consequently, the temperature of the polishing pad is increased and polishing produces uneven effects (low inplane uniformity), often resulting in varied Cu-removal rates and Cu-dishing sizes.

The pH is not particularly limited and may be adjusted appropriately as required. For example, the pH may be rendered alkaline by adding a pH adjuster such as potassium hydroxide.

[Kit for preparing CMP aqueous dispersion]

The CMP aqueous dispersion may be prepared by adding the vinylpyrrolidone homopolymer, the oxidant, the protective film-forming agent and the abrasive grains to water. It may be used as it is in chemical mechanical polishing. Alternatively, the CMP aqueous dispersion containing the components in high concentrations, that is, concentrated aqueous dispersion may be prepared and be diluted to a desired concentration when used in chemical mechanical polishing.

Still alternatively, as described below, a plurality of liquids containing any of the components (for example, two or three liquids) may be prepared and be mixed when used. In this case, the liquids may be mixed together to give a CMP aqueous dispersion, and the aqueous dispersion may be supplied to a CMP apparatus. Alternatively, the liquids may be separately supplied to a CMP apparatus and be allowed to form a CMP aqueous dispersion on a turntable.

<First kit>

A first kit for preparing a CMP aqueous dispersion (hereinafter, kit) is a combination of a liquid (I) which is an aqueous dispersion containing water, the vinylpyrrolidone homopolymer, the protective film-forming agent and the abrasive grains, and a liquid (II) containing water and the oxidant. The liquids are mixed together to give the aforesaid CMP aqueous dispersion.

The concentrations of the components in the liquids (I) and (II) are not particularly limited as long as the CMP aqueous dispersion obtained by mixing the liquids has the above-described concentrations of the components. For example, the liquids (I) and (II) may contain the components in concentrations higher than those in the CMP aqueous dispersion, and the liquids (I) and (II) may be diluted and be mixed to give the CMP aqueous dispersion having the aforesaid concentrations of the components when used. Specifically, when the liquids (I) and (II) are mixed in a weight ratio of 1:1, the liquids (I) and (II) may contain the components in concentrations two times as high as in the CMP aqueous dispersion. The liquids (I) and (II) having concentrations more than two times as high as in the CMP aqueous dispersion may be prepared, they may be mixed in a weight ratio of 1:1, and the CMP aqueous dispersion may be diluted with water to the aforesaid concentrations of the components.

By separately preparing the liquids (I) and (II), the storage stability of the aqueous dispersion, particularly the storage stability of the liquid containing the oxidant may be improved.

With the first kit, the method and timing of mixing the liquids (I) and (II) are not particularly limited as long as the liquids form the CMP aqueous dispersion in the polishing. For example, the liquids (I) and (II) may be mixed together and the CMP aqueous dispersion obtained may be supplied to a CMP apparatus. Alternatively, the liquids (I) and (II) may be separately supplied to a CMP apparatus and may be mixed together on a turntable. Still alternatively, the liquids (I) and (II) may be separately supplied to a CMP apparatus, and the liquids may be mixed in feed lines in the apparatus, or may be mixed in a mixing tank provided in the CMP apparatus. The line mixing may use a line mixer to make the aqueous dispersion more uniform.

<Second kit>

A second kit is a combination of a liquid (III) which is an aqueous dispersion containing water and the abrasive grains, and a liquid (IV) containing water and the protective film-forming agent. The liquids are mixed together to give the aforesaid CMP aqueous dispersion. The vinylpyrrolidone homopolymer and the oxidant are independently contained in either or both of the liquids (III) and (IV).

The concentrations of the components in the liquids (III) and (IV) are not particularly limited as long as the CMP aqueous dispersion obtained by mixing the liquids have the above-described concentrations of the components. For example, the liquids (III) and (IV) may contain the components in concentrations higher than those in the CMP aqueous dispersion, and the liquids (III) and (IV) may be diluted and be mixed to give the CMP aqueous dispersion having the aforesaid concentrations of the components when used. Specifically, when the liquids (III) and (IV) are mixed in a weight ratio of 1:1, the liquids (III) and (IV) may contain the components in concentrations two times as high as in the CMP aqueous dispersion. The liquids (III) and (IV) containing the components in concentrations more than two times as high as in the CMP aqueous dispersion may be prepared, they may be mixed in a weight ratio of 1:1, and the CMP aqueous dispersion may be diluted with water to the aforesaid concentrations of the components.

By separately preparing the liquids (III) and (IV), the storage stability of the aqueous dispersion may be improved.

With the second kit, the method and timing of mixing the liquids (III) and (IV) are not particularly limited as long as the liquids form the CMP aqueous dispersion in the polishing. For example, the liquids (III) and (IV) may be mixed together and the CMP aqueous dispersion obtained may be supplied to a CMP apparatus. Alternatively, the liquids (III) and (IV) may be separately supplied to a CMP apparatus and may be mixed together on a turntable. Still alternatively, the liquids (III) and (IV) may be separately supplied to a CMP apparatus, and the liquids may be mixed in feed lines in the apparatus, or may be mixed in a mixing tank provided in the CMP apparatus. The line mixing may use a line mixer to make the aqueous dispersion more uniform.

<Third kit>

A third kit is a combination of a liquid (V) which is an aqueous dispersion containing water and the abrasive grains, a liquid (VI) containing water and the protective film-forming agent, and a liquid (VII) containing water and the oxidant. The liquids are mixed together to give the aforesaid CMP aqueous dispersion. At least one of the liquids (V), (VI) and (VII) contains the vinylpyrrolidone homopolymer.

The concentrations of the components in the liquids (V), (VI) and (VII) are not particularly limited as long as the CMP aqueous dispersion obtained by mixing the liquids have the above-described concentrations of the components. For example, the liquids (V), (VI) and (VII) may contain the components in concentrations higher than those in the CMP aqueous dispersion, and the liquids (V), (VI) and (VII) may be diluted and be mixed to give the CMP aqueous dispersion having the aforesaid concentrations of the components when used. Specifically, when the liquids (V), (VI) and (VII) are mixed in a weight ratio of 1:1:1, the liquids (V), (VI) and (VII) may contain the components in concentrations three times as high as in the CMP aqueous dispersion. The liquids (V), (VI) and (VII) containing the components in concentrations more than three times as high as in the CMP aqueous dispersion may be prepared, they may be mixed in a weight ratio of 1:1:1, and the CMP aqueous dispersion may be diluted with water to the aforesaid concentrations of the components.

By separately preparing the liquids (V), (VI) and (VII), the storage stability of the aqueous dispersion, particularly the storage stability of the liquid containing the oxidant may be improved.

With the third kit, the method and timing of mixing the liquids (V), (VI) and (VII) are not particularly limited as long as the liquids form the CMP aqueous dispersion in the polishing. For example, the liquids (V), (VI) and (VII) may be mixed together and the CMP aqueous dispersion obtained may be supplied to a CMP apparatus. Alternatively, the liquids (V), (VI) and (VII) may be separately supplied to a CMP apparatus and may be mixed together on a turntable. Still alternatively, the liquids (V), (VI) and (VII) may be separately supplied to a CMP apparatus, and the liquids may be mixed in feed lines in the apparatus, or may be mixed in a mixing tank provided in the CMP apparatus. The line mixing may use a line mixer to make the aqueous dispersion more uniform.

[CMP process and process for producing semiconductor devices]

The CMP process and process for producing semiconductor devices according to the present invention will be described in detail with reference to the drawings. Polishing objects in the CMP process and production process of semiconductor devices are not limited to the structures illustrated in the drawings as long as they are substrates having a metal film on the surface.

<Production 1 of semiconductor devices>

(Fabrication of semiconductor device material)

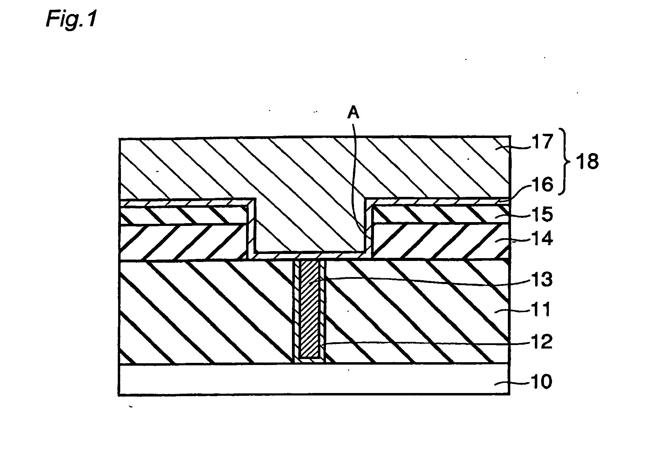

As shown in Fig. 1, a semiconductor substrate 10 with semiconductor elements (not shown) is provided. A $SiO_2$ insulating film 11 is formed on the semiconductor substrate, and a plug 13 is formed through a barrier metal 12. The barrier metal 12 may be TiN, and the plug 13 may be formed of W. A first low-dielectric constant insulating film 14 and a second low-dielectric constant insulating film 15 are sequentially formed to produce a laminated insulating film. The first low-dielectric constant insulating film 14 may be composed of a low-dielectric constant insulating material having a relative dielectric constant of less than 2.5. The first low-dielectric constant insulating films may comprise, for example, at least one film selected from the group consisting of films having a siloxane skeleton such as polysiloxane, hydrogen silosesquioxane, polymethyl siloxane and methyl silosesquioxane; films based on organic resins such as polyarylene ether, polybenzoxazole and polybenzocyclobutene; and porous films such as porous silica films.

The second low-dielectric constant insulating film 15 functions as a cap insulating film and may be composed of an insulating material having a relative dielectric constant higher than that of the first low-dielectric constant insulating film 14. Specifically, the second low-dielectric constant insulating films may be formed of an insulating material having a relative dielectric constant of not less than 2.5, which comprises at least one material selected from the group consisting of TEOS (tetraethoxysilane), SiC, SiCH, SiCN, SiOC and SiOCH.

A wiring concave groove A is formed in the second low-dielectric constant insulating film 15 and first low-dielectric constant insulating film 14. A barrier metal 16 is formed over the entire surface by depositing a Ta film by an established method, and a Cu film 17 is deposited thereon. The barrier metal 16 and the Cu film 17 compose a metal film 18. The wiring groove A may form a fine wiring or a wide wiring.

(First chemical mechanical polishing)

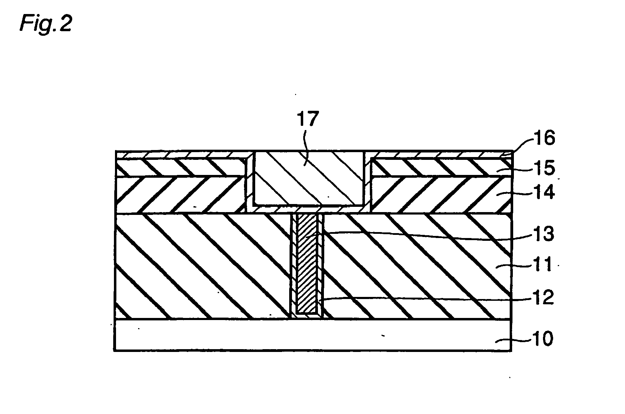

The semiconductor device material fabricated as above is subjected to CMP to remove the Cu film 17 of the metal film 18 with the CMP aqueous dispersion. Consequently, as shown in Fig. 2, the surface of the barrier metal 16 is exposed and the wiring groove A is filled with the Cu film.

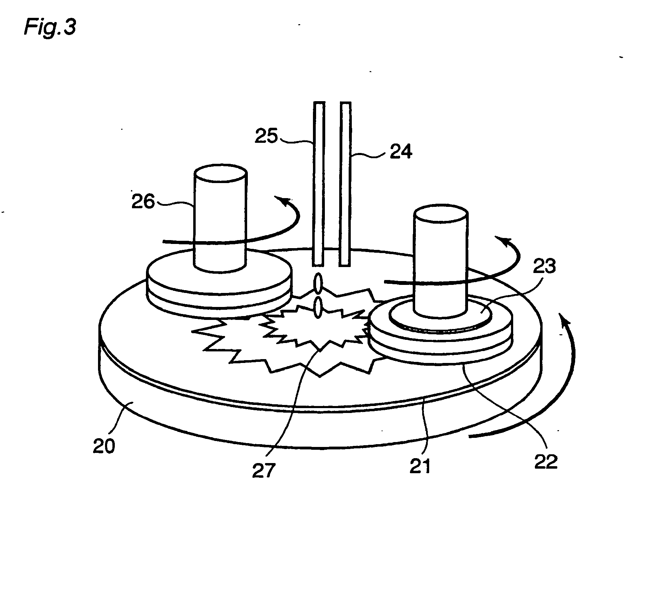

The Cu film 17 is chemically mechanically polished as shown in Fig. 3. While the CMP aqueous dispersion (slurry 27) is supplied from a slurry supply nozzle 25 and a turntable 20 to which a polishing pad 21 is attached is rotated, a top ring 23 holding the semiconductor substrate 22 is brought into contact with the turntable. Fig. 3 shows a water supply nozzle 24 and a dresser 26.

The top ring 23 may apply a polishing load in the range of 10 to 1,000 $gf/cm^2$, preferably 30 to 500 $gf/cm^2$. The rotation of the turntable 20 and the top ring 23 may be in the range of 10 to 400 rpm, preferably 30 to 150 rpm. The flow rate of the slurry 27 from the slurry supply nozzle 25 may be in the range of 10 to 1,000 cc/min, preferably 50 to 400 cc/min.

(Second chemical mechanical polishing (touch-up CMP))

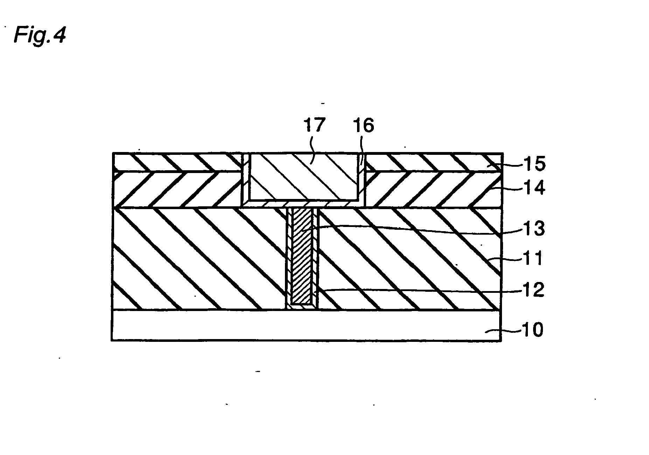

After the extra Cu film 17 is removed by the first chemical mechanical polishing, the barrier metal 16 exposed on the material surface is polished (touch-up CMP) as required with the CMP aqueous dispersion. Consequently, the surface of the second low-dielectric constant insulating film 15 is exposed as shown in Fig. 4.

The touch-up CMP is performed as shown in Fig. 3. While the CMP aqueous dispersion (slurry 27) is supplied from the slurry supply nozzle 25 and the turntable 20 to which the polishing pad 21 is attached is rotated, the top ring 23 holding the semiconductor substrate 22 is brought into contact with the turntable.

The top ring 23 may apply a polishing load in the range of 10 to 1,000 $gf/cm^2$, preferably 30 to 500 $gf/cm^2$. The rotation of the turntable 20 and the top ring 23 may be in the range of 10 to 400 rpm, preferably 30 to 150 rpm. The flow rate of the slurry 27 from the slurry supply nozzle 25 may be in the range of 10 to 1,000 cc/min, preferably 50 to 400 cc/min.

<Production 2 of semiconductor devices>

(Fabrication of semiconductor device material)

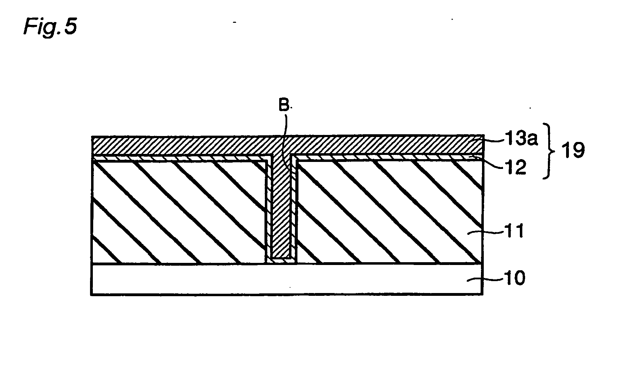

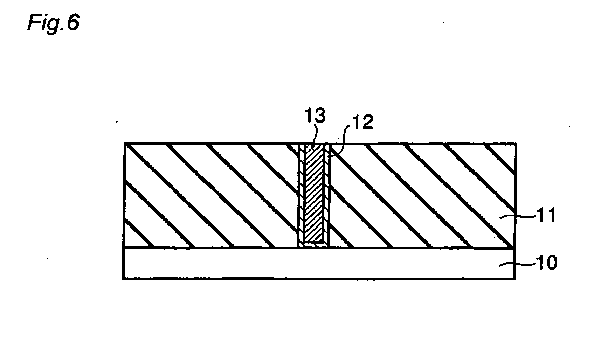

The CMP process of the invention may apply to the production of semiconductor devices as shown in Fig. 6. This embodiment will be described in detail with reference to Figs. 5 and 6.

As shown in Fig. 5, a semiconductor substrate 10 with semiconductor elements (not shown) is provided. A $SiO_2$ insulating film 11 is formed on the semiconductor substrate, and a concave hole B is formed. A barrier metal 12 and a plug material film 13a are deposited thereon sequentially. The barrier metal 12 may be formed by depositing a TiN film, and the plug material film 13a may be formed by depositing a W film.

The semiconductor device material fabricated as above is subjected to CMP to remove selectively a metal film 19 containing the plug material film 13a and the barrier metal 12. Consequently, as shown in Fig. 6, the hole B is filled with a plug 13 through the barrier metal 12.

The metal film 19 may be chemically mechanically polished in the same manner as the first and second CMP in <Production 1 of semiconductor devices>.

## EFFECT OF THE INVENTION

The CMP aqueous dispersion according to the present invention is capable of uniformly and stably polishing a metal film at low friction without causing defects in the metal film and the insulating film and has excellent removal selectivity with respect to a Cu film. The kits of the invention provide this CMP aqueous dispersion. The chemical mechanical polishing process is capable of uniformly and stably polishing a metal film at low friction without causing defects in the metal film and the insulating film and is capable of selective CMP of a Cu film. The process for producing semiconductor devices produces semiconductor devices having a damascene wiring and high reliability.

## EXAMPLES

The present invention will be described by examples without limiting the scope of the invention.

**EP 1 757 665 B1**

<Preparation of aqueous dispersions containing inorganic particles>

(1) Preparation of aqueous dispersion containing fumed silica particles

2 kg of fumed silica particles (AEROSIL No. 90 manufactured by Japan Aerosil, average primary particle diameter: 20 nm) was dispersed in 6.7 kg of ion exchange water with an ultrasonic disperser. The dispersion was filtered through a 5 μm filter. Consequently, an aqueous dispersion containing fumed silica particles was obtained. The average secondary particle diameter of fumed silica in the aqueous dispersion was 220 nm.

(2) Preparation of aqueous dispersion containing colloidal silica particles

A flask was charged with 70 parts by mass of 25% by mass ammonia water, 40 parts by mass of ion exchange water, 170 parts by mass of ethanol and 20 parts by mass of tetraethoxysilane. The temperature was raised to 60°C with stirring at 180 rpm. The stirring was performed for 2 hours at 60°C, and the liquid was cooled to room temperature. Consequently, an alcohol dispersion of colloidal silica particles was obtained.
The alcohol was evaporated with a rotary evaporator while maintaining the dispersion at 80°C and adding ion exchange water. The evaporation was repeated several times, resulting in an aqueous dispersion containing 20% by mass of colloidal silica particles.
The colloidal silica particles in the aqueous dispersion had an average primary particle diameter of 25 nm and an average secondary particle diameter of 40 nm. The colloidal silica particles in the aqueous dispersion will be referred to as C25.
Aqueous dispersions of colloidal silica particles as shown in Table 1 were prepared as described above except that the amounts of ammonia water, ethanol and tetraethoxysilane were changed.

Table 1

| Colloidal silica | Colloidal silica content in aqueous dispersion (wt%) | Average primary particle diameter (nm) | Average secondary particle diameter (nm) |
|---|---|---|---|
| C15 | 20.0 | 15 | 25 |
| C20 | 20.0 | 20 | 35 |
| C25 | 20.0 | 25 | 40 |
| C35 | 20.0 | 35 | 70 |
| C40 | 20.0 | 40 | 75 |

<Preparation of aqueous vinylpyrrolidone homopolymer solution>

A 500 ml flask was charged with 60 g of degassed N-vinyl-2-pyrrolidone and 240 g of degassed water. These were heated to 60°C with stirring under a stream of nitrogen, and 0.3 g of a 10% by mass aqueous sodium sulfite solution and 0.3 g of a 10% by mass aqueous t-butylhydroperoxide solution were added, followed by stirring at 60°C for 3 hours. Subsequently, 1.8 g of a 10% by mass aqueous sodium sulfite solution and 1.2 g of a 10% by mass aqueous t-butylhydroperoxide solution were added, followed by stirring for 3 hours. The reaction mixture was diluted with ion exchange water. Consequently, a 20% by mass aqueous vinylpyrrolidone homopolymer solution was obtained. The vinylpyrrolidone homopolymer was analyzed by aqueous gel permeation chromatography using an eluting solution containing 0.1 mol/L aqueous NaCl solution/acetonitrile = 80/20 (by volume), resulting in a weight-average molecular weight (Mw) in terms of polyethylene glycol of 1,000,000. The K value was determined to be 95. The polyvinylpyrrolidone in the aqueous solution will be referred to as PVP K95.
Seven types of aqueous vinylpyrrolidone homopolymer solutions as shown in Table 2 were prepared in the same manner as described above, except that the amounts of the 10% by mass aqueous sodium sulfite solution and 10% by mass aqueous t-butylhydroperoxide solution were changed. The polymer content in the solutions was 20% by mass.

Table 2

| Polymer | Weight-average molecular weight | K value |
|---|---|---|
| PVP K30 | 25,000 | 30 |

(continued)

| Polymer | Weight-average molecular weight | K value |
|---|---|---|
| PVP K60 | 250,000 | 60 |
| PVP K70 | 400, 000 | 70 |
| PVP K80 | 600,000 | 80 |
| PVP K90 | 800,000 | 90 |
| PVP K110 | 1,500,000 | 110 |
| PVP K140 | 3,000,000 | 140 |

[Reference Example 1]

I. Preparation of CMP aqueous dispersion

A polyethylene bottle was sequentially charged with the following components in amounts corresponding to the following concentration:

abrasive grains: 0.5% by mass in terms of silica of the aqueous dispersion containing colloidal silica C25 prepared above;
vinylpyrrolidone homopolymer: 0.02% by mass in terms of vinylpyrrolidone homopolymer of the aqueous solution containing PVP K60 prepared above;
water-soluble complex-forming agent: 0.3% by mass of alanine;
water-insoluble complex-forming agent: 0.5% by mass of quinaldinic acid;
surface active agent: 0.1% by mass of potassium dodecylbenzenesulfonate; and
oxidant: 2% by mass of ammonium persulfate.

Potassium hydroxide was added to adjust the pH to approximately 9. These were stirred for 15 minutes, and ion exchange water was added to make the total volume 100% by mass. The mixture was filtered through a 5 μm filter. Consequently, a CMP aqueous dispersion S1 was obtained. The aqueous dispersion S1 was measured for viscosity at 25°C with a B-type viscometer, resulting in 1.1 mPa·s. The pH was 9.1.

II. Evaluation of polishing properties

II-1. Polishing test with unpatterned substrates

(1) Evaluation of removal rate with materials

A porous polyurethane polishing pad (IC1000-050-(603)-(P)-S400J, manufactured by Nitta Hass Incorporated) was set to a CMP apparatus (EPO112 manufactured by Ebara Corporation). The following test substrates were chemically mechanically polished under the following polishing conditions for 1 minute while supplying the CMP aqueous dispersion S1. The removal rate was determined as described below.

<Substrates for testing removal rate)

An 8-inch silicon substrate with a thermally oxidized film on which a copper film 20,000 Å in thickness was formed
An 8-inch silicon substrate with a thermally oxidized film on which a tantrum film 3,000 Å in thickness was formed
An 8-inch silicon substrate with a thermally oxidized film on which a titanium film 3,000 Å in thickness was formed

<Polishing conditions>

Head rotation: 80 rpm
Head load: 200 g/cm²
Turntable rotation: 100 rpm

Supply rate of CMP aqueous dispersion: 200 ml/min

<Determination of removal rate>

The resistance of the polished sheet was measured by a DC four point probe method with a resistivity processor (S-5 manufactured by NPS, INC.), and the thickness of the polished metal film was calculated from the following formula. The removal rate was calculated from the thickness reduced by CMP and the polishing time, and the results were as follows.

Metal film thickness (Å) = sheet resistance ($\Omega/cm^2$) ÷ theoretical resistance of each metal ($\Omega/cm$) x $10^8$

<Removal rate>

Removal rate with copper film ($R_{Cu}$): 9,600 Å/min
Removal rate with tantrum film ($R_{Ta}$): 30 Å/min
Removal rate with titanium film ($R_{Ti}$): 80 Å/min
Ratio of removal rate with copper film to removal rate with tantrum film ($R_{Cu}/R_{Ta}$): 320
Ratio of removal rate with copper film to removal rate with titanium film ($R_{Cu}/R_{Ti}$): 120

The maximum torque current of the turntable of the CMP apparatus during polishing the copper film was 8.0 A.

(2) Test of continuous polishing of copper

Substrates having a copper film were consecutively polished under the same conditions as in the evaluation of removal rate, and the reduction of removal rate during the consecutive polishing was studied.

The removal rate was not lowered while 25 substrates were consecutively polished.

II-2. Polishing test with patterned substrates

Patterned wafers (SEMATECH 854 manufactured by SEMATECH INTERNATIONAL, test substrates having various copper patterns) were chemically mechanically polished under the same conditions as in Polishing test with unpatterned substrates, except that the polishing was performed for 1.3 times longer than the period from the initiation of the polishing to the termination detected based on change in turntable torque current. The residual copper on the fine wiring pattern, and the dishing and corrosion of the copper wiring were evaluated as follows.

<Residual copper on fine wiring pattern>

The patterned wafer had a pattern in which wires 0.18 $\mu$m in width and insulating areas 0.18 $\mu$m in width (both 1.6 mm in length) were alternately contiguous. A precision profiler (HRP-240 manufactured by KLA-Tencor Corporation) measured the thickness of the copper film remaining on the wires and the insulating areas over 1.25 mm in a direction perpendicular to the longitudinal direction. The thickness was measured to be 10 Å.

The residual copper film not more than 100 Å in thickness may be easily removed by the second CMP with the CMP aqueous dispersion for removing the barrier metal.

<Dishing in copper wiring>

The patterned wafer had a pattern in which copper wires 100 $\mu$m in width and insulating areas 100 $\mu$m in width (both 3.0 mm in length) were alternately contiguous.
A precision profiler (HRP-240 manufactured by KLA-Tencor Corporation) measured the depth of dishing in the copper wires over 3.0 mm in a direction perpendicular to the longitudinal direction. The depth was measured to be 200 Å.

<Corrosion>

A 1 cm square copper area was analyzed with a defect inspection system (2351 manufactured by KLA-Tencor Corporation), and corrosions as large as 10 to 100 $nm^2$ were counted. No corrosions exceeded 100 $nm^2$ in size.

[Examples 1 to 5, Reference Examples 2 and 3, and Comparative Examples 1 to 3]

CMP aqueous dispersions S2 to S18 and R1 to R3 were prepared in the same manner as in Reference Example 1, except that the types and amounts of the components for the CMP aqueous dispersions were changed as shown in Tables 3 and 4. The aqueous dispersions were adjusted to a pH of approximately 9 by addition of potassium hydroxide in the same manner as in Reference Example 1. Tables 3 and 4 show actual pH values measured after addition of potassium hydroxide. In Table 3, the hyphen (-) indicates that the component was not added. Examples 5 to 3, 5 and Comparative Examples 2 and 3 used two types of particles as abrasive grains in combination. Example 14 used two types of water-soluble complex-forming agents in combination. Example 15 used two types of surface active agents in combination. Examples 5 to 12, 14, 15 and Comparative Examples 2 and 3 used two types of water-insoluble complex-forming agents in combination.

The CMP aqueous dispersions were evaluated in the same manner as evaluating the CMP aqueous dispersion S1 in Reference Example 1. The results are shown in Table 5.

In Examples, Reference Examples, and Comparative Examples, no corrosions exceeded 100 nm$^2$ in size.

The test of continuous polishing of copper in Comparative Example 1 resulted in approximately 50% reduction of removal rate when the fifth substrate was polished.

Table 3-1

| | | Ex. 1-4 and Reference Examples 1-3 | Ex. 5-12 | Ex. 13 | Ex. 14 | Ex. 15 |
|---|---|---|---|---|---|---|
| Abrasive grains | Type | C25 | C20+C40 | C20+fumed silica | C40 | C15+C35 |
| | Amount (parts by mass) | 0.5 | 0.4+0.1 | 0.3+0.05 | 0.5 | 0.3+0.2 |
| Water-soluble complex forming agent | Type | Alanine | Glycine | Glycine | Alanine + ammonia | Alanine |
| | Amount (parts by mass) | 0.3 | 0.5 | 0.3 | 0.5+0.1 | 0.3 |
| Water-insoluble complex forming agent | Type | Quinaldinic acid | Quinaldinic acid + quinolinic acid | Quinolinic acid | Quinaldinic acid + quinolinic acid | Quinaldinic acid + quinolinic acid |
| | Amount (parts by mass) | 0.5 | 0.3+0.2 | 0.5 | 0.2+0.3 | 0.3+0.2 |
| Surface active agent | Type | DBS-K | DBS-A | DBS-K | DBS-A | DBS-K+ACD |
| | Amount (parts by mass) | 0.1 | 0.05 | 0.05 | 0.1 | 0.1+0.1 |
| Oxidant | Type | APS | APS | APS | Hydrogen peroxide | APS |
| | Amount (parts by mass) | 2.0 | 1.5 | 1.5 | 0.2 | 1.5 |
| PVP | Type | See Table 4 | See Table 4 | PVP K95 | PVP K95 | PVP K95 |
| | Amount (parts by mass) | See Table 4 | See Table 4 | 0.03 | 0.03 | 0.03 |
| Slurry viscosity (mPa·s) | | See Table 4 | See Table 4 | 1.2 | 1.2 | 1.2 |

(continued)

|  | Ex. 1-4 and Reference Examples 1-3 | Ex. 5-12 | Ex. 13 | Ex. 14 | Ex. 15 |
|---|---|---|---|---|---|
| Slurry pH | See Table 4 | See Table 4 | 9.1 | 9.2 | 9.0 |

DBS-K: Potassium dodecylbenzenesulfoante
DBS-A: Ammonium dodecylbenzenesulfonate
ACD: Surfynol 465(trade name, manufactured by Air Products And Chemicals, Inc., acetylene diol surface active agent)
APS: Ammonium persulfate
PVP: Polyvinylpyrrolidone

Table 3-2

| | | Comp. Ex. 1 | Comp. Ex. 2 | Comp. Ex. 3 |
|---|---|---|---|---|
| Abrasive grains | Type | C25 | C20+C40 | C20+C40 |
| | Amount (parts by mass) | 0.5 | 0.4+0.1 | 0.4+0.1 |
| Water-soluble complex forming agent | Type | Alanine | Glycine | Glycine |
| | Amount (parts by mass) | 0.3 | 0.5 | 0.5 |
| forming agent | Water-insoluble complex Type | Quinaldinic acid | Quinaldinic add + quinolinic acid | Quinaldinic acid + quinolinic acid |
| | Amount (parts by mass) | 0.5 | 0.3+0.2 | 0.3+0.2 |
| Surface active agent | Type | DBS-K | DBS-A | DBS-A |
| | Amount (parts by mass) | 0.1 | 0.05 | 0.05 |
| Oxidant | Type | APS | APS | APS |
| | Amount (parts by mass) | 2.0 | 1.5 | 1.5 |
| PVP | Type | - | PVP K30 | PVP K80 |
| | Amount (parts by mass) | - | 1.0 | 1.0 |
| Slurry viscosity (mPa·s) | | 1.1 | 1.1 | 3.8 |
| Slurry pH | | 9.1 | 9.0 | 9.1 |

DBS-K: Potassium dodecylbenzenesulfoante
DBS-A: Ammonium dodecylbenzenesulfonate
ACD: Surfynol 465(trade name, manufactured by Air Products And Chemicals, Inc., acetylene diol surface active agent)
APS: Ammonium persulfate
PVP: Polyvinylpyrrolidone

Table 4

| | vinylpyrrolidone homopolymer | | Slurry viscosity (mPa·s) | Slurry pH |
|---|---|---|---|---|
| | Type | Amount (parts by mass) | | |
| Reference Ex. 1 | PVP K60 | 0.02 | 1.1 | 9.1 |
| Reference Ex. 2 | PVP K60 | 0.1 | 1.1 | 9.0 |
| Reference Ex. 3 | PVP K60 | 0.3 | 1.2 | 9.1 |
| Ex. 1 | PVP K70 | 0.1 | 1.1 | 9.1 |
| Ex. 2 | PVP K70 | 0.3 | 1.3 | 9.0 |
| Ex. 3 | PVP K80 | 0.05 | 1.1 | 9.2 |
| Ex. 4 | PVP K80 | 0.1 | 1.2 | 9.1 |
| Ex. 5 | PVP K90 | 0.05 | 1.2 | 9.2 |
| Ex. 6 | PVP K90 | 0.1 | 1.4 | 9.0 |
| Ex. 7 | PVP K95 | 0.03 | 1.2 | 9.1 |
| Ex. 8 | PVP K95 | 0.05 | 1.4 | 9.0 |
| Ex. 9 | PVP K110 | 0.01 | 1.1 | 9.1 |
| Ex. 10 | PVP K110 | 0.05 | 1.6 | 9.1 |
| Ex. 11 | PVP K140 | 0.2 | 1.9 | 9.0 |
| Ex. 12 | PVP K140 | 0.01 | 1.6 | 9.2 |

Table 5-1

| | Test of polishing unpatterned substrates | | | | | | | Test of polishing patterned substrates | | |
| | Removal rate (A/min) | | | Removal rate ratio | | Maximum turntable torque current during Cu polishing (A) | Continuous polishing of copper | Residual copper on fine wiring pattern (Å) | Dishing in copper wiring (Å) | Corrosion (number) |
| | Copper | Tantrum | Titanium | Cu/Ta | Cu/Ti | | Reduction of removal rate after continuous polishing of 25 substrates | | | |
|---|---|---|---|---|---|---|---|---|---|---|
| Reference Ex. 1 | 9600 | 30 | 80 | 320 | 120 | 8.0 | No | 10 | 200 | 10 |
| Reference Ex. 2 | 9500 | 15 | 65 | 633 | 146 | 7.8 | No | 10 | 190 | 8 |
| Reference Ex. 3 | 8500 | 12 | 50 | 708 | 170 | 7.5 | No | 20 | 170 | 7 |
| Ex. 1 | 9100 | 13 | 60 | 700 | 152 | 7.7 | No | 10 | 180 | 4 |
| Ex. 2 | 8400 | 10 | 30 | 840 | 280 | 7.5 | No | 20 | 160 | 2 |
| Ex. 3 | 9000 | 16 | 55 | 563 | 164 | 7.6 | No | 10 | 170 | 0 |
| Ex. 4 | 8800 | 11 | 50 | 800 | 176 | 7.5 | No | 10 | 150 | 0 |
| Ex. 5 | 9200 | 10 | 40 | 920 | 230 | 7.4 | No | 0 | 130 | 0 |
| Ex. 6 | 8300 | 9 | 35 | 922 | 237 | 7.5 | No | 0 | 100 | 0 |
| Ex. 7 | 8800 | 18 | 65 | 489 | 135 | 7.4 | No | 0 | 150 | 0 |

Table 5-2

| | Test of polishing unpatterned substrates | | | | | | | Test of polishing patterned substrates | | |
| | Removal rate (Å/min) | | | Removal rate ratio | | Maximum turntable torque current during Cu polishing (A) | Continuous polishing of copper | Residual copper on fine wiring pattern (Å) | Dishing in copper wiring (Å) | Corrosion (number) |
| | Copper | Tantrum | Titanium | Cu/Ta | Cu/Ti | | Reduction of removal rate after continuous polishing of 25 substrates | | | |
|---|---|---|---|---|---|---|---|---|---|---|
| Ex. 8 | 9000 | 8 | 30 | 1125 | 300 | 7.5 | No | 0 | 110 | 0 |
| Ex. 9 | 8900 | 20 | 55 | 445 | 162 | 7.8 | No | 0 | 160 | 2 |
| Ex. 10 | 8400 | 7 | 20 | 1200 | 420 | 7.5 | No | 20 | 100 | 0 |
| Ex. 11 | 8200 | 6 | 15 | 1367 | 547 | 7.5 | No | 60 | 80 | 0 |
| Ex. 12 | 8000 | 8 | 40 | 1000 | 200 | 7.7 | No | 100 | 200 | 2 |
| Ex. 13 | 10200 | 15 | 60 | 680 | 170 | 7.5 | No | 0 | 190 | 3 |
| Ex. 14 | 8300 | 18 | 70 | 461 | 119 | 7.4 | No | 0 | 200 | 4 |
| Ex. 15 | 8800 | 20 | 75 | 440 | 117 | 7.5 | No | 0 | 130 | 0 |
| Comp. Ex. 1 | 10200 | 50 | 130 | 204 | 78 | 10.2 | Yes | 150 | 500 | 30 |
| Comp. Ex. 2 | 9800 | 45 | 120 | 218 | 82 | 8.0 | No | 30 | 400 | 20 |
| Comp. Ex. 3 | 4500 | 5 | 10 | 900 | 450 | 12.0 | No | 300 | 60 | 0 |

[Example 16]

I. Preparation of kit for preparing CMP aqueous dispersion

I-1. Preparation of liquid (I)

A polyethylene bottle was sequentially charged with the following components in amounts corresponding to the following concentration:

abrasive grains: 0.6% by mass in terms of silica of the aqueous dispersion containing colloidal silica C15 prepared above, and 0.4% by mass in terms of silica of the aqueous dispersion containing colloidal silica C35 prepared above; vinylpyrrolidone homopolymer: 0.06% by mass in terms of vinylpyrrolidone homopolymer of the aqueous solution containing PVP K95 prepared above;
water-soluble complex-forming agent: 0.6% by mass of alanine;
water-insoluble complex-forming agents: 0.6% by mass of quinaldinic acid, and 0.4% by mass of quinolinic acid; and surface active agents: 0.2% by mass of potassium dodecylbenzenesulfonate, and 0.2% by mass of acetylene diol surface active agent (trade name: SURFYNOL 465 manufactured by Air Products and Chemicals, Inc.).

Potassium hydroxide was added to adjust the pH to approximately 10.5. These were stirred for 15 minutes, and ion exchange water was added to make the total volume 100% by mass. The mixture was filtered through a 5 $\mu$m filter. Consequently, a liquid (aqueous dispersion) (I-1) was obtained.

I-2. Preparation of liquid (II)

Ammonium persulfate and ion exchange water were mixed together such that the ammonium persulfate concentration was 3% by mass. Consequently, a liquid (II-1) was obtained.

II. Preparation of CMP aqueous dispersion

50 parts by mass of the liquid (I-1) and 50 parts by mass of the liquid (II-1) were mixed together to give a CMP aqueous dispersion S19. The CMP aqueous dispersion S19 had a pH of 9.0 and a viscosity of 1.2 mPa · s as measured at 25°C with a B-type viscometer. The CMP aqueous dispersion S19 produced by mixing the separately prepared liquids (I-1) and (II-1) was identical to the CMP aqueous dispersion S18 produced by simultaneously mixing the components (see Table 6).

Table 6

| | | Ex. 15 | Ex. 16 | |
| --- | --- | --- | --- | --- |
| | | | Liquid(I-1) | Liquid(II-1) |
| Abrasive grains | Type | C15+C35 | C15+C35 | |
| | Amount (parts by mass) | 0.3+0.2 | 0.6+0.4 | |
| Water-soluble complex forming agent | Type | Alanine | Alanine | |
| | Amount (parts by mass) | 0.3 | 0.6 | |
| Water-insolubte complex forming agent | Type | Quinaldinic acid + quinolinic acid + | Quinaldinic acid quinolinlc acid | |
| | Amount (parts by mass) | 0.3+0.2 | 0.6+0.4 | |
| Surface active agent | Type | DBS-K+ACD | DBS-K+ACD | |
| | Amount (parts by mass) | 0.1+0.1 | 0.2+0.2 | |

(continued)

| | | Ex. 15 | Ex. 16 | |
|---|---|---|---|---|
| | | | Liquid(I-1) | Liquid(II-1) |
| Oxidant | Type | APS | | APS |
| | Amount (parts by mass) | 1.5 | | 3.0 |
| PVP | Type | PVP K95 | PVP K95 | |
| | Amount (parts by mass) | 0.03 | 0.06 | |
| Mixing ratio (by weight) | | | 50 | 50 |
| Slurry viscosity (mPa·s) | | 1.2 | 1.2 | |
| Slurry pH | | 9.0 | 9.0 | |

DBS-K: Potassium dodecylbenzenesulfonate
ACD: Surfynol 465(trade name, manufactured by Air Products And Chemicals, Inc., acetylene diol surface active agent)
APS: Ammonium persulfate
PVP: Polyvinylpyrrolidone

III. Evaluation of polishing properties

The CMP aqueous dispersion S19 was evaluated in the same manner as evaluating the CMP aqueous dispersion S18 in Example 15. The results were identical to those of the CMP aqueous dispersion S18.

[Example 17]

The liquids (I-1) and (II-1) prepared in Example 16 were supplied to a CMP apparatus each at a rate of 100 ml/min, and the liquids were brought into contact and mixed together on a turntable. The polishing properties were evaluated in the same manner as in Example 15. The results were identical to those of the CMP aqueous dispersion S18.

[Example 18]

I. Preparation of kit for preparing CMP aqueous dispersion

I-1. Preparation of liquid (III)

A polyethylene bottle was sequentially charged with the following components in amounts corresponding to the following concentration:

abrasive grains: 2.0% by mass in terms of silica of the aqueous dispersion containing colloidal silica C40 prepared above; and
0.8% by mass in terms of hydrogen peroxide of a 35% by mass hydrogen peroxide solution.

Potassium hydroxide was added to adjust the pH to approximately 9. These were stirred for 15 minutes, and ion exchange water was added to make the total volume 100% by mass. The mixture was filtered through a 5 μm filter. Consequently, a liquid (aqueous dispersion) (III-1) was obtained.

I-2. Preparation of liquid (IV)

A polyethylene bottle was sequentially charged with the following components in amounts corresponding to the following concentration:

vinylpyrrolidone homopolymer: 0.12% by mass in terms of vinylpyrrolidone homopolymer of the aqueous solution containing PVP K95 prepared above;

water-soluble complex-forming agents: 2.0% by mass of alanine, and 0.4% by mass of ammonia;
water-insoluble complex-forming agents: 0.8% by mass of quinaldinic acid, and 1.2% by mass of quinolinic acid; and
surface active agent: 0.4% by mass of ammonium dodecylbenzenesulfonate.

Potassium hydroxide was added to adjust the pH to approximately 9. These were stirred for 15 minutes, and ion exchange water was added to make the total volume 100% by mass. The mixture was filtered through a 5 $\mu$m filter. Consequently, a liquid (aqueous dispersion) (IV-1) was obtained.

II. Preparation of CMP aqueous dispersion

25 parts by mass of the liquid (III-1), 25 parts by mass of the liquid (IV-1) and 50 parts by mass of ion exchange water were mixed together to give a CMP aqueous dispersion S20. The CMP aqueous dispersion S20 had a pH of 9.2 and a viscosity of 1.2 mPa·s as measured at 25°C with a B-type viscometer. The CMP aqueous dispersion S20 produced by mixing the separately prepared liquids (III-1) and (IV-1) was identical to the CMP aqueous dispersion S17 produced by simultaneously mixing the components (see Table 7).

Table 7

| | | Ex. 14 | Ex. 18 | | |
|---|---|---|---|---|---|
| | | | Liquid(III-1) | Liquid(IV-1) | Ion exchange water |
| Abrasive grains | Type | C40 | C40 | | |
| | Amount (parts by mass) | 0.5 | 2.0 | | |
| Water-soluble complex forming agent | Type | Alanine + ammonia | | Alanine + ammonia | |
| | Amount (parts by mass) | 0.5+0.1 | | 2.0+0.4 | |
| Water-insoluble complex forming agent | Type | Quinaldinic acid + quinolinic acid | | Quinaldinic acid + quinolinic acid | |
| | Amount (parts by mass) | 0.2+0.3 | | 0.8+1.2 | |
| Surface active agent | Type | DBS-A | | DBS-A | |
| | Amount (parts by mass) | 0.1 | | 0.4 | |
| Oxidant | Type | Hydrogen peroxide | Hydrogen peroxide | | |
| | Amount (parts by mass) | 0.2 | 0.8 | | |
| PVP | Type | PVP K95 | | PVP K95 | |
| | Amount (parts by mass) | 0.03 | | 0.12 | |
| Mixing ratio (by weight) | | | 25 | 25 | 50 |
| Slurry viscosity (mPa·s) | | 1.2 | 1.2 | | |
| Slurry pH | | 9.2 | 9.2 | | |
| DBS-A: Ammonium dodecylbenzenesulfonate PVP: Polyvinylpyrrolidone | | | | | |

III. Evaluation of polishing properties

The CMP aqueous dispersion S20 was evaluated in the same manner as evaluating the CMP aqueous dispersion S17 in Example 14. The results were identical to those of the CMP aqueous dispersion S17.

[Example 19]

I. Preparation of kit for preparing CMP aqueous dispersion

I-1. Preparation of liquid (V)

A polyethylene bottle was sequentially charged with the following components in amounts corresponding to the following concentration:

abrasive grains: 1.2% by mass in terms of silica of the aqueous dispersion containing colloidal silica C15 prepared above, and 0.8% by mass in terms of silica of the aqueous dispersion containing colloidal silica C35 prepared above.

Potassium hydroxide was added to adjust the pH to approximately 10.5. These were stirred for 15 minutes, and ion exchange water was added to make the total volume 100% by mass. The mixture was filtered through a 5 $\mu$m filter. Consequently, a liquid (aqueous dispersion) (V-1) was obtained.

I-2. Preparation of liquid (VI)

A polyethylene bottle was sequentially charged with the following components in amounts corresponding to the following concentration:

vinylpyrrolidone homopolymer: 0.12% by mass in terms of vinylpyrrolidone homopolymer of the aqueous solution containing PVP K95 prepared above;
water-soluble complex-forming agent: 1.2% by mass of alanine;
water-insoluble complex-forming agents: 1.2% by mass of quinaldinic acid, and 0.8% by mass of quinolinic acid; and surface active agents: 0.4% by mass of potassium dodecylbenzenesulfonate, and 0.4% by mass of acetylene diol surface active agent (trade name: SURFYNOL 465 manufactured by Air Products and Chemicals, Inc.).

Potassium hydroxide was added to adjust the pH to approximately 10.5. These were stirred for 15 minutes, and ion exchange water was added to make the total volume 100% by mass. The mixture was filtered through a 5 $\mu$m filter. Consequently, a liquid (aqueous dispersion) (VI-1) was obtained.

I-3. Preparation of liquid (VII)

A liquid containing 3% by mass of ammonium persulfate (VII-1) was prepared in the same manner as in I-2 of Example 16.

II. Preparation of CMP aqueous dispersion

25 parts by mass of the liquid (V-1), 25 parts by mass of the liquid (VI-1) and 50 parts by mass of the liquid (VII-1) were mixed together to give a CMP aqueous dispersion S21. The CMP aqueous dispersion S21 had a pH of 9.0 and a viscosity of 1.2 mPa·s as measured at 25°C with a B-type viscometer. The CMP aqueous dispersion S21 produced by mixing the separately prepared liquids (V-1), (VI-1) and (VII-1) was identical to the CMP aqueous dispersion S18 produced by simultaneously mixing the components (see Table 8).

Table 8

| | | | Ex. 15 | Ex. 19 | | |
|---|---|---|---|---|---|---|
| | | | | Liquid(V-1) | Liquid(VI-1) | Liquid (VII-1) |
| Abrasive grains | | Type | C15+C35 | C15+C35 | | |
| | | Amount (parts by mass) | 0.3+0.2 | 1.2+0.8 | | |
| Water-soluble complex forming agent | | Type | Alanine | | Alanine | |
| | | Amount (parts by mass) | 0.3 | | 1.2 | |
| Water-insoluble complex forming agent | | Type | Quinaldinic acid + quinolinic acid | | Quinaldinic acid + quinolinic acid | |
| | | Amount (parts by mass) | 0.3+0.2 | | 1.2+0.8 | |
| Surface active agent | | Type | DBS-K+ACD | | DBS-K+ACD | |
| | | Amount (parts by mass) | 0.1+0.1 | | 0.4+0.4 | |
| Oxidant | | Type | APS | | | APS |
| | | Amount (parts by mass) | 1.5 | | | 3.0 |
| PVP | | Type | PVP K95 | | PVP K95 | |
| | | Amount (parts by mass) | 0.03 | | 0.12 | |
| Mixing ratio (by weight) | | | | 25 | 25 | 50 |
| Slurry viscosity (mPa·s) | | | 1.2 | 1.2 | | |
| Slurry pH | | | 9.0 | 9.0 | | |

DBS-K: Potassium dodecylbenzenesulfonate
ACD: Surfynol 465(trade name, manufactured by Air Products And Chemicals, Inc., acetylene diol surface active agent)
APS: Ammonium persulfate
PVP: Polyvinylpyrrolidone

III. Evaluation of polishing properties

The CMP aqueous dispersion S21 was evaluated in the same manner as evaluating the CMP aqueous dispersion S18 in Example 15. The results were identical to those of the CMP aqueous dispersion S18.

[Example 20]

The liquids (V-1), (VI-1) and (VII-1) prepared in Example 22 were supplied to a CMP apparatus at rates of 50 ml/min, 50 ml/min and 100 ml/min, independently, in place of the CMP aqueous dispersion S18 in Example 15, and the liquids were brought into contact and mixed together on a surface plate. The polishing properties were evaluated in the same manner as in Example 15. The results were identical to those of the CMP aqueous dispersion S18.

[Example 21]

50 parts by mass of the liquid (V-1) and 50 parts by mass of the liquid (VI-1) prepared in Example 19 were mixed together to give a CMP aqueous dispersion.
The aqueous dispersion and the liquid (VII-1) prepared in Example 19 were supplied to a CMP apparatus each at a rate of 100 ml/min in place of the CMP aqueous dispersion S18 in Example 15, and the aqueous dispersion was brought into contact and mixed with the liquid on a surface plate. The polishing properties were evaluated in the same manner as in Example 15. The results were identical to those of the CMP aqueous dispersion S18.
An aqueous dispersion for chemical mechanical polishing contains water, a vinylpyrrolidone homopolymer having a weight-average molecular weight of from 300,000 to 1,500,000 as determined by aqueous GPC, an oxidant, a protective film-forming agent and abrasive grains, the protective film-forming agent containing a first metal compound-forming agent which forms a water-insoluble metal compound, and a second metal compound-forming agent which forms a water-soluble metal compound. The aqueous dispersion is capable of uniformly and stably polishing a metal film at low friction without causing defects in a metal film and an insulating film.

**Claims**

1.  An aqueous dispersion for chemical mechanical polishing, comprising
    water,
    a vinylpyrrolidone homopolymer having a weight average molecular weight of from 300,000 to 1,500,000 as determined by aqueous GPC,
    an oxidant,
    a protective film-forming agent and
    abrasive grains,
    the protective film-forming agent comprising a first metal compound-forming agent which forms a water-insoluble metal compound, and
    a second metal compound-forming agent which forms a water-soluble metal compound.

2.  The aqueous dispersion for chemical mechanical polishing according to claim 1, wherein the water-insoluble metal compound is a water-insoluble complex.

3.  The aqueous dispersion for chemical mechanical polishing according to claim 1 or 2, wherein the water-soluble metal compound is a water-soluble complex.

4.  A chemical mechanical polishing process comprising:

    a step of bringing a semiconductor substrate having a metal film into contact with a polishing pad attached to a turntable; and

5.  A process for producing semiconductor devices, comprising:

    a step of forming an insulating film on a semiconductor substrate;
    a step of forming a concave groove in the insulating film;
    a step of depositing a metal in the concave groove and on the insulating film to form a metal film; and
    a step of removing at least part of the metal film deposited on the insulating film by chemical mechanical polishing using the aqueous dispersion of any one of claims 1 to 3.

6. A kit for preparing an aqueous dispersion for chemical mechanical polishing, the kit comprising a liquid (I) and a liquid (II), the liquids being mixed to give the aqueous dispersion of any one of claims 1 to 3, wherein
the liquid (I) is an aqueous dispersion containing water, the vinylpyrrolidone homopolymer, the protective film-forming agent and the abrasive grains, and
the liquid (II) contains water and the oxidant.
a step of polishing a surface of the metal film while dropping the aqueous dispersion of any one of claims 1 to 3 on the polishing pad.

7. A kit for preparing an aqueous dispersion for chemical mechanical polishing, the kit comprising a liquid (III) and a liquid (IV), the liquids being mixed to give the aqueous dispersion of any one of claims 1 to 3, wherein
the liquid (III) is an aqueous dispersion containing water and the abrasive grains,
the liquid (IV) contains water and the protective film-forming agent,
the liquid (III) and/or the liquid (IV) contain the vinylpyrrolidone homopolymer, and
the liquid (III) and/or the liquid (IV) contain the oxidant.

8. A kit for preparing an aqueous dispersion for chemical mechanical polishing, the kit comprising a liquid (V), a liquid (VI) and a liquid (VII), the liquids being mixed to give the aqueous dispersion of any one of claims 1 to 3, wherein
the liquid (V) is an aqueous dispersion containing water and the abrasive grains,
the liquid (VI) contains water and the protective film-forming agent,
the liquid (VII) containing water and the oxidant, and at least one of the liquids (V), (VI) and (VII) contain the vinylpyrrolidone homopolymer.

**Patentansprüche**

1. Wässrige Dispersion zum chemisch-mechanischen Polieren, umfassend Wasser,
ein Vinylpyrrolidonhomopolymer mit einem gewichtsgemittelten Molekulargewicht von 300000 bis 1500000, wie durch wässrige GPC bestimmt,
ein Oxidationsmittel,
ein Schutzfilm-bildendes Agens und
Schleifkörner,
wobei das Schutzfilm-bildende Agens ein erstes Metallverbindung-bildendes Agens, welches eine Wasser-unlösliche Metallverbindung bildet, und
ein zweites Metallverbindung-bildendes Agens, welches eine Wasser-lösliche Metallverbindung bildet, umfasst.

2. Wässrige Dispersion zum chemisch-mechanischen Polieren nach Anspruch 1, wobei die Wasser-unlösliche Metallverbindung ein Wasser-unlöslicher Komplex ist.

3. Wässrige Dispersion zum chemisch-mechanischen Polieren nach Anspruch 1 oder 2, wobei die Wasser-lösliche Metallverbindung ein Wasser-löslicher Komplex ist.

4. Chemisch-mechanisches Polierverfahren, umfassend:

    einen Schritt des In-Kontakt-bringes eines Halbleitersubstrats, das einem Metallfilm aufweist, mit einem Polierpad, das an eine Drehplatte angebracht ist; und
    einen Schritt des Polierens einer Oberfläche des Metallfilms während Tropfens der wässrigen Dispersion nach einem der Ansprüche 1 bis 3 auf das Polierpad.

5. Verfahren zum Herstellen von Halbleiterbauteilen, umfassend:

    einen Schritt des Bildens eines Isolierfilms auf einem Halbleitersubstrat;
    einen Schritt des Bildens einer konkaven Vertiefung in dem Isolierungsfilm;
    einen Schritt des Abscheidens eines Metalls in die konkave Vertiefung und auf den Isolierfilm, um einen Metallfilm zu bilden; und
    einen Schritt des Entfernens zumindest eines Teils des Metallfilms, der auf dem Isolierfilm abgeschieden ist, durch chemisch-mechanisches Polieren unter Verwendung der wässrigen Dispersion nach einem der Ansprüche 1 bis 3.

**6.** Bausatz zum Anfertigen einer wässrigen Dispersion zum chemisch-mechanischen Polieren, wobei der Bausatz eine Flüssigkeit (I) und eine Flüssigkeit (II) umfasst, die Flüssigkeiten gemischt werden, um die wässrige Dispersion nach einem der Ansprüche 1 bis 3 zu ergeben, wobei
die Flüssigkeit (I) eine wässrige Dispersion ist, die Wasser, das Vinylpyrrolidonhomopolymer, das Schutzfilm-bildende Agens und die Schleifkörner enthält, und
die Flüssigkeit (II) Wasser und das Oxidationsmittel enthält.

**7.** Bausatz zum Anfertigen einer wässrigen Dispersion zum chemisch-mechanischen Polieren, wobei der Bausatz eine Flüssigkeit (III) und eine Flüssigkeit (IV) umfasst, die Flüssigkeiten gemischt werden, um die wässrige Dispersion nach einem der Ansprüche 1 bis 3 zu ergeben, wobei
die Flüssigkeit (III) eine wässrige Dispersion ist, die Wasser und die Schleifkörner enthält,
die Flüssigkeit (IV) Wasser und das Schutzfilm-bildende Agens enthält,
die Flüssigkeit (III) und/oder die Flüssigkeit (IV) das Vinylpyrrolidonhomopolymer enthalten, und
die Flüssigkeit (III) und/oder die Flüssigkeit (IV) das Oxidationsmittel enthalten.

**8.** Bausatz zum Anfertigen einer wässrigen Dispersion zum chemisch-mechanischen Polieren, wobei der Bausatz eine Flüssigkeit (V), eine Flüssigkeit (VI) und eine Flüssigkeit (VII) umfasst, die Flüssigkeiten gemischt werden, um die wässrige Dispersion nach einem der Ansprüche 1 bis 3 zu ergeben, wobei
die Flüssigkeit (V) eine wässrige Dispersion ist, die Wasser und die Schleifkörner enthält,
die Flüssigkeit (VI) Wasser und das Schutzfilm-bildende Agens enthält,
die Flüssigkeit (VII) Wasser und das Oxidationsmittel enthält, und zumindest eine der Flüssigkeiten (V), (VI) und (VII) das Vinylpyrrolidonhomopolymer enthalten.

**Revendications**

**1.** Dispersion aqueuse pour polissage chimico-mécanique, comprenant
de l'eau,
un homopolymère de vinylpyrrolidone ayant un poids moléculaire moyen en poids de 300 000 à 1 500 000 comme déterminé par CPG en milieu aqueux,
un oxydant,
un agent de formation de film de protection et des grains abrasifs,
l'agent de formation de film de protection comprenant un premier agent de formation de composé métallique qui forme un composé métallique insoluble dans l'eau, et
un deuxième agent de formation de composé métallique qui forme un composé métallique soluble dans l'eau.

**2.** Dispersion aqueuse pour polissage chimico-mécanique selon la revendication 1, dans laquelle le composé métallique insoluble dans l'eau est un complexe insoluble dans l'eau.

**3.** Dispersion aqueuse pour polissage chimico-mécanique selon la revendication 1 ou 2, dans laquelle le composé métallique soluble dans l'eau est un complexe soluble dans l'eau.

**4.** Procédé de polissage chimico-mécanique comprenant :

une étape de mise d'un substrat semi-conducteur ayant un film métallique en contact avec un tampon de polissage fixé à une table rotative ; et
une étape de polissage d'une surface du film métallique tout en laissant tomber goutte à goutte la dispersion aqueuse selon l'une quelconque des revendications 1 à 3 sur le tampon de polissage.

**5.** Procédé de production de dispositifs semiconducteurs, comprenant :

une étape de formation d'un film d'isolation sur un substrat semi-conducteur ;
une étape de formation d'une rainure concave dans le film d'isolation ;
une étape de dépôt d'un métal dans la rainure concave et sur le film d'isolation pour former un film métallique ; et
une étape d'enlèvement d'au moins une partie du film métallique déposé sur le film d'isolation par polissage chimico-mécanique en utilisant la Dispersion aqueuse selon l'une quelconque des revendications 1 à 3.

6. Kit de préparation d'une dispersion aqueuse pour polissage chimico-mécanique, le kit comprenant un liquide (I) et un liquide (II), les liquides étant mélangés pour donner la dispersion aqueuse selon l'une quelconque des revendications 1 à 3, dans lequel
le liquide (I) est une dispersion aqueuse contenant de l'eau, l'homopolymère de vinylpyrrolidone, l'agent de formation de film de protection et les grains abrasifs, et
le liquide (II) contient de l'eau et l'oxydant.

7. Kit de préparation d'une dispersion aqueuse pour polissage chimico-mécanique, le kit comprenant un liquide (III) et un liquide (IV), les liquides étant mélangés pour donner la dispersion aqueuse selon l'une quelconque des revendications 1 à 3, dans lequel
le liquide (III) est une dispersion aqueuse contenant de l'eau et les grains abrasifs,
le liquide (IV) contient de l'eau et l'agent de formation de film de protection,
le liquide (III) et/ou le liquide (IV) contiennent/contient l'homopolymère de vinylpyrrolidone, et
le liquide (III) et/ou le liquide (IV) contiennent/contient l'oxydant.

8. Kit de préparation d'une dispersion aqueuse pour polissage chimico-mécanique, le kit comprenant un liquide (V), un liquide (VI) et un liquide (VII), les liquides étant mélangés pour donner la dispersion aqueuse selon l'une quelconque des revendications 1 à 3, dans lequel
le liquide (V) est une dispersion aqueuse contenant de l'eau et les grains abrasifs,
le liquide (VI) contient de l'eau et l'agent de formation de film de protection,
le liquide (VII) contient de l'eau et l'oxydant et au moins un des liquides (V), (VI) et (VII) contient l'homopolymère de vinylpyrrolidone.

EP 1 757 665 B1

*Fig.1*

28

*Fig.2*

Fig.3

Fig.4

*Fig.5*

Fig.6

**EP 1 757 665 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003282494 A
- JP 2002270549 A
- JP 2002517593 A
- WO 2005047410 A1
- US 2005037693 A
- JP 2003040911 A